# EUROPÄISCHE PATENTSCHRIFT

(11) **EP 0 603 486 B1**
(45) Veröffentlichungstag und Bekanntmachung des Hinweises auf die Patenterteilung: **04.02.1998**
(21) Anmeldenummer: 93116882.7
(22) Anmeldetag: 19.10.1993
(51) Int. Cl.: C23C 14/02, C23C 14/06, C23C 14/14, C23C 14/32, C23C 14/34

(54) **Verfahren zur mehrstufigen Beschichtung von Substraten**
Process for multi-step coating of substrates
Procédé pour le revêtement en plusieurs étapes des substrats

(30) Priorität: 23.12.1992 DE 4243915
(43) Veröffentlichungstag der Anmeldung: 29.06.1994
(73) Patentinhaber: HAUZER TECHNO COATING EUROPE BV, 5900 AE Venlo (NL)
(72) Erfinder: Münz, Wolf-Dieter, NL-5913 RV Venlo (NL)
(74) Vertreter: Finsterwald, Manfred, Dipl.-Ing., Dipl.-Wirtsch.-Ing.

(56) Entgegenhaltungen:
- WO-A-91/00374
- DE-A- 3 611 492
- DATABASE WPI Section Ch, Week 9526 Derwent Publications Ltd., London, GB; Class L02, AN 95-196887 & JP-A-07 113 171 ( UBE IND LTD) , 2.Mai 1995

## Beschreibung

Die Erfindung betrifft ein Verfahren nach dem Oberbegriff des Anspruchs 1.

Aus der europäischen Patentanmeldung 0 404 973 A1 ist ein solches Verfahren zur zweistufigen Beschichtung bekannt, bei dem das zu beschichtende Substrat, zum Beispiel Materialien zur Herstellung von Schneid- und Umformwerkzeugen, wie Schnellarbeitsstahl oder Hartmetall, derart beschichtet wird, daß das Substrat zunächst im Dampf einer kathodischen Bogenentladung einer Vorbehandlung unterzogen und mit hochenergetischen Metallionen, zum Beispiel 1200 eV, des Schichtmaterials, wie Ti-Ionen im Falle des TiN oder Zr+-Ionen im Falle des ZrN etc., beschossen wird.

Auf diese Weise kann eine Verankerungszone geschaffen werden, auf der dann TiN, ZrN oder CrN mittels Kathodenzerstaubung abgeschieden wird. Dies gilt auch für ternäre Hartstoffschichten wie TiAlN, ZrAlN oder CrAlN.

Im Falle der zuletzt genannten Schichtmaterialien erweist es sich jedoch als Nachteil, daß bei Verwendung von aus zwei Komponenten bestehenden Targetmaterialien, wie zum Beispiel pulvermetallurgisch hergestellten TiAl-, ZrAl- oder CrAl-Targets, bei der genannten Vorbehandlung im Metalldampf der Bogenentladung typische Droplets aus dem niederschmelzenden Material, im vorliegenden Falle Al, auf der Substratoberfläche abgeschieden werden. Diese Droplets stören den homogenen Schichtaufbau und führen zu einer unerwünschten Aufrauhung der Schichtoberfläche.

Aufgabe der Erfindung ist es, dieses Problem zu beseitigen und die Dropletbildung zumindest weitestgehend zu reduzieren.

Gelöst wird diese Aufgabe nach der Erfindung durch ein Verfahren mit den Merkmalen des Patentanspruchs 1.

Wird beispielsweise als zweites Targetmaterial TiAl, ZrAl oder CrAl verwendet, dann wird als erstes Target in der Vorbehandlungsphase ein Target aus Ti, Zr oder Cr verwendet.

Nach einer Ausführungsform der Erfindung wird zur Herstellung des Metalldampfes der höherschmelzenden Komponente eine Legierung dieses Materials verwendet, das heißt im Falle der Verwendung von Ti, Zr oder Cr als höherschmelzendem Material wird eine Legierung mit Ta, Nb oder W verwendet.

Besonders vorteilhaft ist es im Hinblick auf eine weitere Verbesserung der Haftfähigkeit, ein mit W-Ionen vorbehandeltes Substrat vor der Beschichtung mittels Kathodenzerstäubung mit TiAl-, ZrAl- oder CrAl-Targets einer Plasma-Karbonisierung zu unterwerfen.

Eine weitere besonders vorteilhafte Variante der Erfindung besteht darin, daß das Substrat nach der Vorbehandlung mit hochenergetischen W-Ionen des Bogenentladungsplasmas mittels einer weiteren Bogenentladungsverdampfung oder Kathodenzerstäubung mit einer Schicht aus Wolfram beschichtet wird und diese gebildete Schicht einer Plasma-Karbonisierung unterworfen wird, bevor eine Beschichtung TiAlN, ZrAlN oder CrAlN vorgenommen wird.

Weitere besonders vorteilhafte Ausgestaltungen der Erfindung sind in den Unteransprüchen angegeben, wobei sämtliche Merkmale, die in den Patentansprüchen angeführt sind, für die Erfindung wesentlich und zur Lösung der gestellten Aufgabe förderlich sind.

Für die Durchführung der zweistufigen Beschichtungsvorgänge gelten die in der europäischen Anmeldung 0 404 973 A1 beschriebenen Lehren in allgemeiner Weise, wobei die vorstehend erläuterten Modifizierungen besondere oder zusätzliche Maßnahmen darstellen.

## Patentansprüche

1. Verfahren zum mehrstufigen, insbesondere zweistufigen Beschichten von Substraten, wobei das Substrat im Dampf einer kathodischen Bogenentladung vorbehandelt wird und eine Weiterbeschichtung mittels Kathodenzerstäubung erfolgt,
dadurch **gekennzeichnet,**
daß die Kathodenzerstäubung mit einem zweiten Targetmaterial aus TiAl, ZrAl oder CrAl erfolgt, und
daß für die Bogenentladung ein erstes Targetmaterial verwendet wird, das nur aus der höherschmelzenden Komponente des zweiten Targetmaterials oder
aus einer Legierung dieser höherschmelzenden Komponente mit Ta, Nb oder W, oder
aus W oder WC besteht.

2. Verfahren nach Anspruch 1,
dadurch **gekennzeichnet,**
daß bei Verwendung von Ti als erstes Targetmaterial TiAl als zweites Targetmaterial, bei Verwendung von Zr als erstes Targetmaterial ZrAl als zweites Targetmaterial und bei Verwendung Cr als erstes Targetmaterial CrAl als zweites Targetmaterial verwendet wird.

3. Verfahren nach Anspruch 1,
dadurch **gekennzeichnet**,
daß der Anteil von Ta, Nb oder W etwa 2 At% bis 50 At% des Legierungsmaterials beträgt.

4. Verfahren nach Anspruch 3,
dadurch **gekennzeichnet,**
daß der Anteil an Ta, Nb oder W bei etwa 15 At% bis 30 At% liegt.

5. Verfahren nach Anspruch 1,
dadurch **gekennzeichnet**,
daß ein mit Wolfram-Ionen vorbehandeltes Substrat aus Schnellarbeitsstahl vor der Beschichtung mittels Kathodenzerstäubung mit TiAl-, ZrAl- oder CrAl-Targets zur Schaffung einer Hartmetallschicht einer Plasma-Karbonisierung unterworfen wird.

6. Verfahren nach einem der Ansprüche 1 oder 5,
dadurch **gekennzeichnet,**
daß das Substrat nach einer Vorbehandlung mit hochenergetischen Wolfram-Ionen des Bogenentladungsplasmas mittels einer weiteren Bogenentladungsverdampfung oder einer Kathodenzerstäubung mit einer Schicht von etwa 0,05 µm bis etwa 2 µm Dicke aus Wolfram beschichtet wird und diese Schicht vor der Beschichtung mit TiAlN, ZrAlN oder CrAlN einer Plasma-Karbonisierung unterworfen wird.

7. Verfahren nach einem der Ansprüche 1 oder 5,
dadurch **gekennzeichnet,**
daß das Substrat nach einer Vorbehandlung mit hochenergetischen W- und C-Ionen hergestellt in einer kathodischen Bogenentladung unter Verwendung eines WC-Targets mit einer WC-Schicht, ebenfalls mit einem WC-Target, mit einer Dicke von etwa 0,05 µm bis etwa 2 µm beschichtet wird bevor die Beschichtung mittels Kathodenzerstäubung mit TiAl-, ZrAl- oder CrAl-Targets erfolgt.

8. Verfahren nach einem oder mehreren der vorhergehenden Ansprüche,
dadurch **gekennzeichnet**,
daß das erste Targetmaterial gemeinsam in einer Beschichtungsanlage mit den Targets aus TiAl, ZrAl, CrAl eingebaut sind.

9. Verfahren nach einem der Ansprüche 5 oder 6,
dadurch **gekennzeichnet,**
daß die Plasma-Karbonisierung in einer Prozeßfolge mit der Vorbehandlung der Substrate mit hochenergetischen Wolfram-Ionen aus dem Metalldampf der Bogenentladung und die abschließende Beschichtung mittels Kathodenzerstäubung mit TiAlN, ZrAlN und CrAlN in einer Vakuumprozeßfolge, das heißt zeitlich hintereinander in einer Vakuumanlage erfolgt.

## Claims

1. Method for the multi-stage, and in particular two-stage, coating of substrates, wherein the substrate is pre-treated in the vapour of a cathodic arc discharge, and a further coating takes place by means of cathode sputtering, characterized in that the cathode sputtering takes place with a second target material of TiAl, ZrAl or CrAl, and in that a first target material is used for the arc discharge, which only consists of the higher melting point component of the second target material, or of an alloy of this higher melting point component with Ta, Nb or W, or consists of W or WC.

2. Method in accordance with claim 1, characterized in that when using Ti as the first target material, TiAl is used as the second target material, when using Zr as the first target material, ZrAl is used as the second target material, and when using Cr as the first target material, CrAl is used as the second target material.

3. Method in accordance with claim 1, characterized in that the proportion of Ta, Nb or W amounts to approximately 2 At% to 50 At% of the alloy material.

4. Method in accordance with claim 3, characterized in that the proportion of Ta, Nb or W lies at approximately 15 At% to 30 At%.

5. Method in accordance with claim 1, characterized in that a substrate consisting of high speed steel pre-treated with tungsten ions is subjected to a plasma-carbonisation prior to the coating by means of cathode sputtering with TiAl, ZrAl- or CrAl targets for the provision of a hard material layer.

6. Method in accordance with one of the claims 1 or 5, characterized in that the substrate is coated, after a pre-treatment with highly energetic tungsten ions of the arc discharge plasma, by means of a further arc discharge vaporisation treatment or of a cathode sputtering treatment, with a layer of tungsten of about 0.05 µm to about 2 µm thickness, and this layer is subjected to a plasma carbonisation prior to the coating with TiAlN, ZrAlN or CrAlN.

7. Method in accordance with one of the claims 1 or 5, characterized in that the substrate is coated after a pre-treatment with highly energetic W and C ions, produced in a cathodic arc discharge by using a WC target, with a WC layer with a thickness of about 0.05 µm to about 2 µm - likewise using a WC target - before the coating with TiAl, ZrAl, CrAl targets takes place by means of cathode sputtering.

8. Method in accordance with one or more of the preceding claims, characterized in that the first target material is installed in a coating plant together with the targets of TiAl, ZrAl, CrAl.

9. Method in accordance with one of the claims 5 or 6, characterized in that the plasma carbonisation takes place in a process sequence with the pre-treatment of the substrates with highly energetic tungsten ions from the metallic vapour of the arc discharge and the subsequent coating by means of cathode sputtering with TiAlN, ZrAlN, CrAlN takes place in a vacuum process sequence, i.e. timewise one after the other in a vacuum plant.

## Revendications

1. Procédé pour le revêtement en plusieurs étapes, et en particulier en deux étapes, de substrats, le substrat étant traité préalablement dans la vapeur d'une décharge cathodique à arc et un revêtement ultérieur ayant lieu au moyen d'une atomisation cathodique, caractérisé en ce que l'atomisation de la cathode est réalisé avec un deuxième matériau cible à base de TiAl, ZrAl ou CrAl, et en ce que pour la décharge à arc on utilise un premier matériau cible composé uniquement du constituant du second matériau cible ayant le point de fusion le plus élevé ou d'un alliage de ce composant à point de fusion le plus élevé avec Ta, Nb ou W, ou encore de W ou de WC.

2. Procédé selon la revendication 1, caractérisé en ce que pour l'utilisation de Ti comme premier matériau cible on utilise TiAl comme second matériau cible, pour l'utilisation de Zr comme premier matériau cible on utilise ZrAl comme second matériau cible et pour l'utilisation de Cr comme premier matériau cible on utilise CrAl comme second matériau cible.

3. Procédé selon la revendication 1, caractérisé en ce que la proportion de Ta, Nb ou W représente environ 2 % At à 50 % At du matériau d'alliage.

4. Procédé selon la revendication 3, caractérisé en ce que la proportion de Ta, Nb ou W est comprise entre environ 15 % At et 30 % At.

5. Procédé selon la revendication 1, caractérisé en ce qu'avant le revêtement par atomisation cathodique avec des matériaux TiAl, ZrAl ou CrAl, le substrat en acier rapide traité préalablement avec des ions tungstène est soumis à une carbonatation au plasma afin de produire une couche de métal dur.

6. Procédé selon l'une des revendications 1 ou 5, caractérisé en ce qu'après avoir subi un traitement préalable avec des ions tungstène à forte énergie du plasma de la décharge à arc le substrat est recouvert d'une couche de tungstène de 0,05 µm à 2 µm d'épaisseur environ par une autre vaporisation de décharge à arc ou par une atomisation cathodique, et en ce que cette couche de tungstène est soumise, avant le revêtement par TiAlN, ZrAlN ou CrAlN, à une carbonatation au plasma.

7. Procédé selon l'une des revendications 1 ou 5, caractérisé en ce qu'après avoir subi un traitement préalable avec des ions W et C à forte énergie, le substrat est recouvert, lors d'une décharge cathodique à arc avec utilisation d'une cible WC, d'une couche de WC, également avec une cible WC, avec une épaisseur de 0,05 µm à 2 µm environ avant que n'ait lieu le revêtement par atomisation cathodique avec des cibles TiAl, ZrAl, ou CrAl.

8. Procédé selon une ou plusieurs des revendications précédentes, caractérisé en ce que le premier matériau cible est intégré dans une structure de revêtement avec les cibles à base de TiAl, ZrAl ou CrAl.

9. Procédé selon l'une des revendications 5 ou 6, caractérisé en ce que la carbonatation au plasma s'intègre dans une suite de procédures, avec le traitement préalable des substrats avec des ions tungstène à forte énergie dans la vapeur métallique de la décharge à arc et le revêtement final au moyen d'une atomisation de la cathode avec TiAlN, ZrAlN et CrAlN, les différentes procédures se déroulant les unes après les autres dans un appareil à vide.
